# EUROPÄISCHE PATENTSCHRIFT

(11) **EP 2 795 755 B1**
(45) Veröffentlichungstag und Bekanntmachung des Hinweises auf die Patenterteilung: **02.11.2016**
(21) Anmeldenummer: 12795381.8
(22) Anmeldetag: 20.11.2012
(51) Int. Cl.: H02H 1/00, H02H 5/12, G01R 27/16, B60W 10/24

(54) **SCHUTZVORRICHTUNG, VERFAHREN UND ENERGIEVERSORGUNGSSYSTEM**
PROTECTION APPARATUS, METHOD AND POWER SUPPLY SYSTEM
DISPOSITIF DE PROTECTION, PROCÉDÉ ET SYSTÈME D'ALIMENTATION EN ÉNERGIE

(30) Priorität: 20.12.2011 DE 102011089145
(43) Veröffentlichungstag der Anmeldung: 29.10.2014
(73) Patentinhaber: Robert Bosch GmbH, 70442 Stuttgart (DE)
(72) Erfinder: PEUSER, Thomas, 71636 Ludwigsburg (DE); GASE, Stephan, 75233 Tiefenbronn (DE)
(86) Internationale Anmeldenummer: PCT/EP2012/073047
(87) Internationale Veröffentlichungsnummer: WO 2013/092066

(56) Entgegenhaltungen:
- EP-A1- 1 921 457
- EP-A1- 2 353 919
- WO-A1-2011/027010
- DE-B3-102004 018 918

## Beschreibung

Die vorliegende Erfindung bezieht sich auf eine Schutzvorrichtung für ein IT-Netz mit einer ersten und einer zweiten spannungsführenden Leitung, ein Verfahren und ein Energieversorgungsystem.

### Stand der Technik

Energienetze, welche gegenüber Erde elektrisch isoliert sind, werden in unterschiedlichen technischen Anwendungen eingesetzt. Eine mögliche Anwendung für solche sog. IT-Netze (Isolated Terre) sind Hybrid- und Elektrofahrzeuge.

Obwohl der Gegenstand der vorliegenden Erfindung für eine Vielzahl von IT-Netzen eingesetzt werden kann, wird er im Folgenden in Verbindung mit IT-Netzen für Hybrid-oder Elektrofahrzeuge beschrieben.

In der Entwicklung moderner Kraftfahrzeuge ist die Reduzierung des Kraftstoffverbrauchs und damit auch des Schadstoffausstoßes eines der wichtigsten Kriterien für den Entwicklungsingenieur. Um den Kraftstoffverbrauch von Verbrennungsmotoren zu reduzieren, können diese in Hybridfahrzeugen durch einen Elektromotor unterstützt werden. In Elektrofahrzeugen wird der Verbrennungsmotor nicht durch einen Elektromotor unterstützt sondern durch den Elektromotor ersetzt.

In solchen Hybrid- und Elektrofahrzeugen wird ein Hochvoltenergiespeicher, z.B. eine Lithium-Ionen-Batterie, eingesetzt, um die zum Betrieb des Elektromotors nötige elektrische Energie zu speichern. Dieser Hochvoltenergiespeicher wird üblicherweise über zwei Hochvoltleitungen, von denen eine Hochvoltleitung eine positive Spannung und eine Hochvoltleitung eine negative Spannung führt, an einen Wechselrichter übertragen.

Wird ein solches Hybrid- oder Elektrofahrzeug in einer Werkstatt gewartet, können unter Umständen die Hochvoltleitungen freigelegt werden. Werden nach einer Servicetätigkeit an einem Hybrid- oder Elektrofahrzeug die Hochvoltleitungen zwischen der Batterie und dem Wechselrichter nicht ordnungsgemäß mit dem Wechselrichter verbunden, ist es möglich, dass ein Lebewesen, insbesondere ein Mensch, spannungsführende Bestandteile der Hochvoltleitungen berührt.

Ein solches Hybrid- oder Elektrofahrzeug wird beispielsweise in der DE 102008001973 A1 gezeigt.

Auch zeigt die EP 1 921 457 A1, die den nächstliegenden Stand der Technik wiedergibt, eine Schutzvorrichtung für ein IT-Netz mit einem Signalgenerator, einer Erfassungsreinrichtung und einer Steuereinrichtung. Letztere ist derart ausgebildet, dass sie ein Berühren einer spannungsführenden Leitung durch ein Lebewesen anzeigt.

### Offenbarung der Erfindung

Die vorliegende Erfindung offenbart eine Schutzvorrichtung mit den Merkmalen des Patentanspruchs 1, ein Verfahren mit den Merkmalen des Patentanspruchs 5 und ein Energieversorgungssystem mit den Merkmalen des Patentanspruchs 8.

### Demgemäß ist vorgesehen:

Eine Schutzvorrichtung für ein T-Netz mit einer ersten und einer zweiten spannungsführenden Leitung, mit einem Signalgenerator, welcher dazu ausgebildet ist, ein erstes Signal in die erste und/oder die zweite spannungsführende Leitung einzuspeisen, mit einer Erfassungseinrichtung, welche dazu ausgebildet ist, den Verlauf des eingespeisten ersten Signals in mindestens einer spannungsführenden Leitung zu erfassen und mit einer Steuereinrichtung, welche dazu ausgebildet ist, den erfassten Verlauf zu analysieren und ein Abschaltsignal auszugeben, wenn die Analyse des erfassten Verlaufs ein Berühren der ersten spannungsführenden Leitung und der zweiten spannungsführenden Leitung durch ein Lebewesen anzeigt.

Ein Verfahren zum Schutz von Lebewesen für ein IT-Netz mit einer ersten und einer zweiten spannungsführenden Leitung, mit den Schritten Einspeisen eines ersten Signals in die erste und/oder die zweite spannungsführende Leitung, Erfassen des Verlaufs des eingespeisten ersten Signals in der mindestens einen spannungsführenden Leitung, Analysieren des erfassten Verlaufs und Ausgeben eines Abschaltsignals, wenn die Analyse des erfassten Verlaufs ein Berühren der ersten spannungsführenden Leitung und der zweiten spannungsführenden Leitung durch ein Lebewesen anzeigt.

Ein Energieversorgungsystem mit mindestens einer Hochvoltbatterie, mit einem Hochspannungszwischenkreis, welcher einen Zwischenkreiskondensator aufweist, mit mindestens zwei Hochspannungsleitungen, welche die Hochvoltbatterie mit dem Zwischenkreiskondensator verbinden, mit mindestens einer steuerbaren Schaltvorrichtung, welche dazu ausgebildet ist, die zwei Hochspannungsleitungen elektrisch von der Hochvoltbatterie zu trennen, mit einer Schutzvorrichtung nach einem der Ansprüche 1 - 5, welche zumindest mit einer der Hochspannungsleitungen gekoppelt ist und welche dazu ausgebildet ist, die mindestens eine steuerbare Schaltvorrichtung mittels eines Abschaltsignals derart anzusteuern, dass diese die zwei Hochspannungsleitungen elektrisch von der Hochvoltbatterie trennt, wenn ein Berühren der spannungsführenden Leitungen durch ein Lebewesen erkannt wird.

### Vorteile der Erfindung

Die der vorliegenden Erfindung zu Grunde liegende Erkenntnis besteht darin, dass Lebewesen eine frequenzabhängige Impedanz aufweisen und diese frequenzabhängige Impedanz genutzt werden kann, um zu erkennen, ob ein Lebewesen die spannungsführenden Leitungen eines IT-Netzes berührt.

Die der vorliegenden Erfindung zu Grunde liegende Idee besteht nun darin, dieser Erkenntnis Rechnung zu tragen und eine Schutzvorrichtung für IT-Netze bereitzustellen, welche die spannungsführenden Leitungen des IT-Netzes auf das Vorhandensein einer für ein Lebewesen charakteristischen Impedanz untersucht und ein Abschaltsignal ausgibt, falls eine solche für Lebewesen charakteristische Impedanz in den spannungsführenden Leitungen des IT-Netzes erkannt wird.

Dazu sieht die vorliegende Erfindung vor, ein erstes Signal in die spannungsführenden Leitungen einzuspeisen und Anhand des Verlaufs des Signals innerhalb der spannungsführenden Leitungen zu erkennen, ob ein Lebewesen die spannungsführenden Leitungen berührt. Als Verlauf des Signals innerhalb der spannungsführenden Leitungen wird auch das auf Grund einer Impedanz innerhalb der spannungsführenden Leitungen reflektierte und/oder veränderte erste Signal verstanden.

Als erstes Signal ist dabei jedes Signal geeignet, welches es ermöglicht, die Impedanz innerhalb der spannungsführenden Leitungen über ein vorgegebenes Frequenzspektrum zu erfassen. Dabei weist das vorgegebene Frequenzspektrum mindestens diejenigen Frequenzen auf, welche es ermöglichen, eine charakteristische Impedanz eines Lebewesens zu erkennen.

Vorteilhafte Ausführungsformen und Weiterbildungen ergeben sich aus den Unteransprüchen sowie aus der Beschreibung unter Bezugnahme auf die Figuren.

In einer Ausführungsform weist der Signalgenerator eine steuerbare Spannungsquelle und/oder eine steuerbare Stromquelle auf. Ferner ist das erste Signal ein Spannungsimpuls oder ein Stromimpuls. Wird eine steuerbare Spannungsquelle oder eine steuerbare Stromquelle eingesetzt, um einen Spannungsimpuls oder einen Stromimpuls als erstes Signal zu erzeugen, wird eine sehr flexible Anpassung der Spannungsschutzvorrichtung an unterschiedliche Anwendungsfälle möglich.

In einer weiteren Ausführungsform weist der Signalgenerator eine Spule mit einem Schaltelement auf, wobei das Schaltelement dazu ausgebildet ist, die Spule mit einer Spannungsquelle zu verbinden und die Spule zum Erzeugen des ersten Signals in Form eines Spannungsimpulses von der Spannungsquelle zu trennen. Wird eine Spule als Signalgenerator eingesetzt, wird ein sehr einfacher Aufbau des Signalgenerators und damit ein sehr einfacher Aufbau Schutzvorrichtung ermöglicht.

In einer weiteren Ausführungsform weist die Erfassungseinrichtung einen Spannungssensor, welcher dazu ausgebildet ist, eine Spannung in der mindestens einen spannungsführenden Leitung zu erfassen, und/oder einen Stromsensor, welcher dazu ausgebildet ist, eine Stromstärke in der mindestens einen spannungsführenden Leitung zu erfassen, auf. Wird, um den Verlauf des ersten Signals zu erfassen, erfindungsgemäß der Verlauf der Spannung und/oder der Verlauf des Stroms innerhalb der spannungsführenden Leitungen erfasst, kann die Impedanz in den spannungsführenden Leitungen sehr leicht über dem vorgegebenen Frequenzspektrum erfasst werden.

In einer weiteren Ausführungsform weist die Steuereinrichtung einen analog/digital-Wandler auf, welcher dazu ausgebildet ist, die erfasste Spannung und/oder die erfasste Stromstärke in einen für die erfasste Spannung und/oder die erfasste Stromstärke kennzeichnenden digitalen Wert zu wandeln. Dies ermöglicht es den Verlauf der erfassten Spannung und/oder der erfassten Stromstärke in einer programmgesteuerten Vorrichtung, z.B. einem Mikrocontroller weiter zu verarbeiten.

In einer weiteren Ausführungsform weist die Steuereinrichtung einen Speicher auf, welcher dazu ausgebildet ist, eine Vielzahl von für den Verlauf des eingespeisten ersten Signals in der mindestens einen spannungsführenden Leitung kennzeichnenden digitalen Werten zu speichern, wobei die Steuereinrichtung eine Transformationseinrichtung aufweist, welche dazu ausgebildet ist, für den gespeicherten zeitlichen Verlauf des eingespeisten ersten Signals eine Transformation in den Frequenzbereich, insbesondere eine Fast-Fourier-Transformation, durchzuführen und Daten auszugeben, welche den Verlauf des eingespeisten ersten Signals im Frequenzbereich kennzeichnen. Ferner weist die Steuereinrichtung eine Auswerteeinrichtung auf, welche dazu ausgebildet ist, in den gespeicherten Daten diejenigen Frequenzen zu identifizieren, bei welchen die Impedanz der spannungsführenden Leitungen Iokale Maxima oder Minima aufweist, und das Abschaltsignal auszugeben, wenn mindestens eine der identifizierten Frequenzen in mindestens einem vorgegebenen Frequenzbereich zur Erkennung eines Lebewesens liegt.

Wird eine Transformation des Signalverlaufs in den Zeitbereich vorgenommen, wird es sehr einfach möglich, die frequenzabhängige Impedanz innerhalb der spannungsführenden Leitungen zu analysieren. Da die frequenzabhängige Impedanz von Lebewesen an bestimmten Frequenzen Minima oder Maxima aufweist, kann im Frequenzbereich sehr leicht erkannt werden, ob die charakteristische frequenzabhängige Impedanz eines Lebewesens in dem Signalverlauf vorhanden ist. Dadurch kann mit einfachen Berechnungen sehr sicher ein Abschaltsignal ausgegeben werden.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmalen der Erfindung. Insbesondere wird dabei der Fachmann auch Einzelaspekte als Verbesserungen oder Ergänzungen zu der jeweiligen Grundform der vorliegenden Erfindung hinzufügen.

### Kurze Beschreibung der Zeichnungen

Die vorliegende Erfindung wird nachfolgend anhand der in den schematischen Figuren der Zeichnungen angegebenen Ausführungsbeispiele näher erläutert. Es zeigen dabei:
- Fig. 1: ein Blockdiagramm einer Ausführungsform einer erfindungsgemäßen Schutzvorrichtung 1;
- Fig. 2: ein Ablaufdiagramm einer Ausführungsform eines erfindungsgemäßen Verfahrens;
- Fig. 3: ein Blockdiagramm einer Ausführungsform eines erfindungsgemäßen Energieversorgungsystems;
- Fig. 4: einen Schaltplan, der die elektrische Ersatzschaltung eines Menschen darstellt;
- Fig. 5: ein Diagramm in welchem eine frequenzabhängige Impedanz dargestellt ist.

In allen Figuren sind gleiche bzw. funktionsgleiche Elemente und Vorrichtungen - sofern nichts Anderes angegeben ist - mit denselben Bezugszeichen versehen worden.

### Ausführungsformen der Erfindung

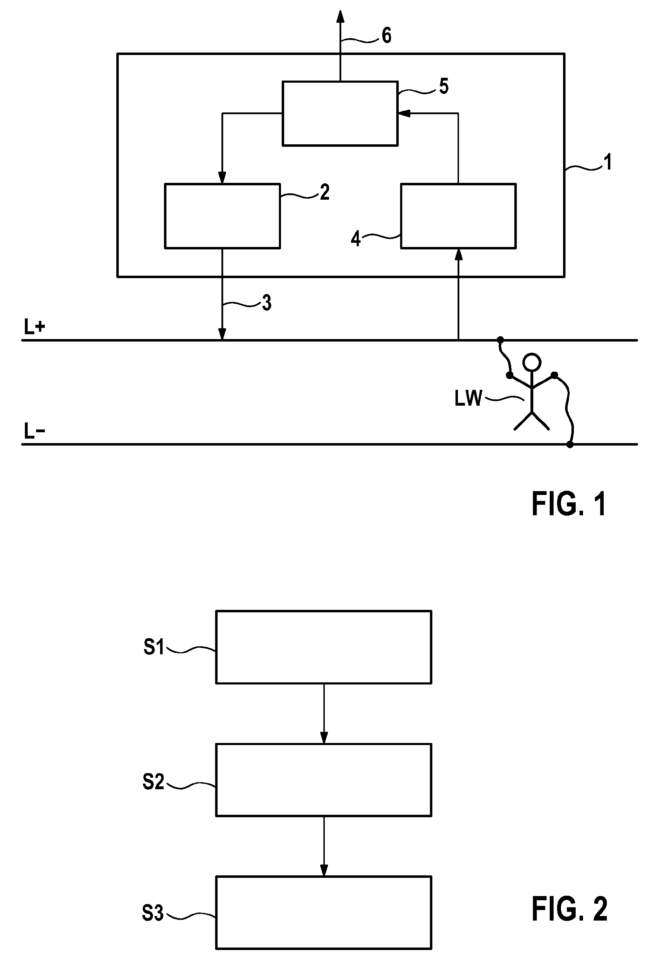

Fig. 1 zeigt ein Blockdiagramm einer Ausführungsform einer erfindungsgemäßen Schutzvorrichtung 1.

Die Schutzvorrichtung 1 in Fig. 1 weist einen Signalgenerator 2 auf, welcher mit einer Steuereinrichtung 5 gekoppelt ist und welcher von der Steuereinrichtung 5 gesteuert wird. Ferner weist die Schutzvorrichtung 1 eine Erfassungseinrichtung 4 auf, welche dazu ausgebildet ist, einen Verlauf eines Signals in den spannungsführenden Leitungen L+, L-zu erfassen und der Steuereinrichtung 5 bereitzustellen. Ferner ist die Steuereinrichtung 5 dazu ausgebildet, ein Abschaltsignal 6 auszugeben.

Schließlich weist die Fig. 1 zwei spannungsführende Leitungen L+, L- eines IT-Netzes auf, welche von einem Lebewesen LW, welches in Form eines Strichmännchens LW dargestellt ist, mit jeweils einer Hand berührt werden. Der Signalgenerator 2 ist mit der spannungsführenden Leitung L+ gekoppelt, um ein erstes Signal 3 in diese einzuspeisen und die Erfassungseinrichtung 4 ist mit der spannungsführenden Leitung L+ gekoppelt, um den Verlauf des eingespeisten Signals in der spannungsführenden Leitung L+ zu erfassen.

Die Steuereinrichtung 5 in Fig. 1 ist als Mikrocontroller 5 ausgebildet, welcher ein Computerprogrammprodukt ausführt, welches die gewünschte Funktionalität bereitstellt. In weiteren Ausführungsformen kann die Steuereinrichtung 5 als anwendungsspezifischer integrierter Schaltkreis 5 oder dergleichen ausgebildet sein.

In noch weiteren Ausführungsformen weist die Steuereinrichtung 5 eine CAN-Busschnittstelle oder eine FlexRay-Schnittstelle auf, über welche die Steuereinrichtung 5 Daten über das Erkennen eines Lebewesens an weitere Fahrzeugsteuereinrichtung übermitteln kann. Dadurch können z.B. weitere Aktionen im Fahrzeug, wie z.B. das Auslösen eines Notrufs oder das Abschalten des Verbrennungsmotors ausgelöst werden.

Fig. 2 zeigt ein Ablaufdiagramm einer Ausführungsform eines erfindungsgemäßen Verfahrens.

In einem ersten Schritt S1 wird ein erstes Signal 3 in die erste und/oder die zweite spannungsführende Leitung L+, L- eingespeist. In einem zweiten Schritt S2 wird der Verlauf des eingespeisten ersten Signals 3 in der mindestens einen spannungsführenden Leitung L+, L- erfasst. Schließlich wird in einem dritten Schritt S3 der erfasste Verlauf analysiert und ein Abschaltsignal 6 ausgegeben, wenn die Analyse des erfassten Verlaufs ein Berühren der ersten spannungsführenden Leitung L+ und der zweiten spannungsführenden Leitung L- durch ein Lebewesen LW anzeigt.

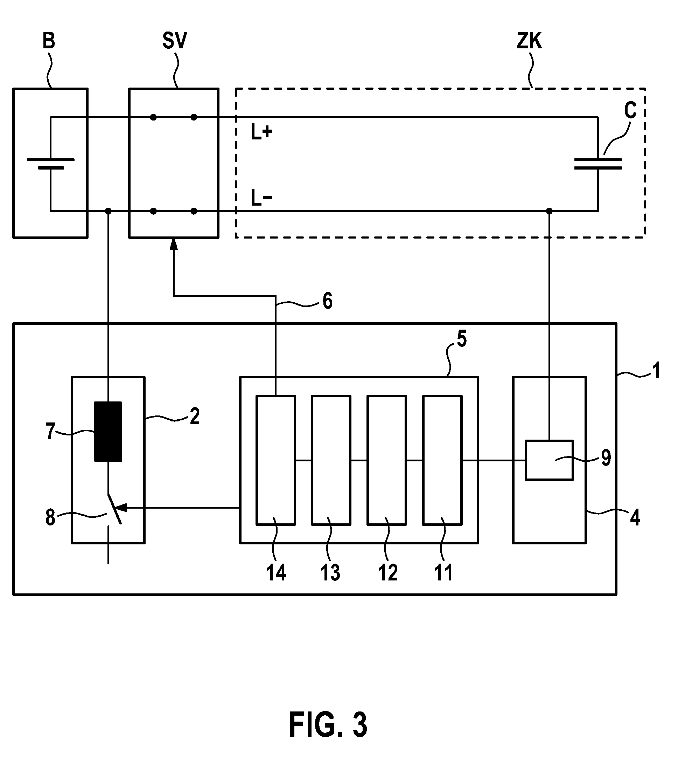

Fig. 3 zeigt ein Blockdiagramm einer Ausführungsform eines erfindungsgemäßen Energieversorgungsystems.

Das Energieversorgungssystem in Fig. 3 weist eine Batterie B auf, welche über zwei spannungsführende Leitungen L+, L- elektrisch mit einem Schütz SV gekoppelt ist, welcher dazu ausgebildet ist, die zwei spannungsführenden Leitungen zu unterbrechen. Der Schütz ist über die zwei spannungsführenden Leitungen L+, L- mit einem Kondensator eines Hochspannungszwischenkreises gekoppelt.

Ferner weist Fig. 3 eine Schutzvorrichtung 1 auf, welche mit dem Hochspannungszwischenkreis ZK gekoppelt ist.

Im Gegensatz zu Fig. 1 weist der Signalgenerator 2 in Fig. 3 eine Spule 7 und ein Schaltelement 8 auf, welches dazu ausgebildet ist, die Spule 7 mit einer Spannungsquelle (nicht gezeigt) zu koppeln und die Spule 7 von der Spannungsquelle zu trennen und welches von der Steuereinrichtung 5 gesteuert wird. Das Trennen der Spule 7 von der Spannungsquelle führt dazu, dass auf Grund der Induktivität der Spule 7 ein Spannungsimpuls in die Leitung L- des Energieversorgungssystems eingespeist wird.

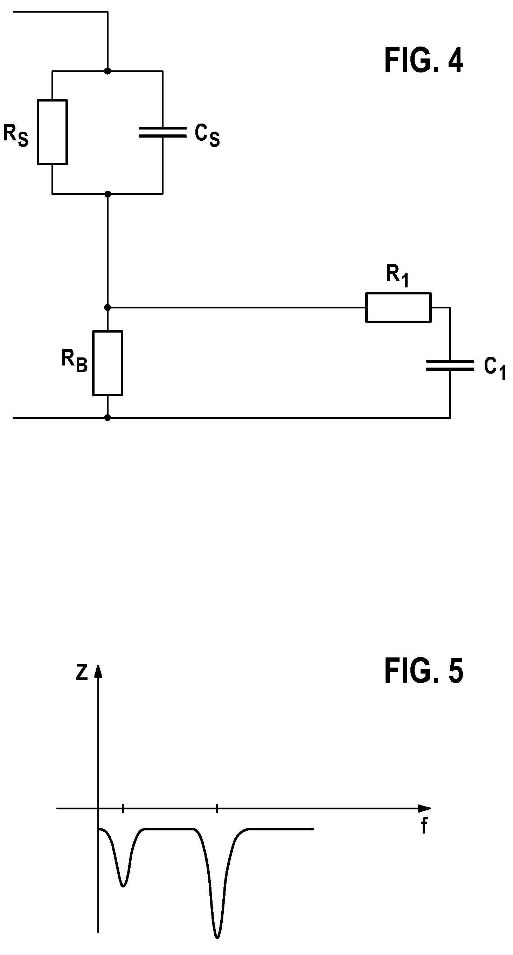

Ferner weist die Erfassungseinrichtung 4 in Fig. 4 einen Spannungs- und Stromsensor 9 auf, welcher dazu ausgebildet ist, Werte der Spannung und Werte der Stromstärke in der spannungsführenden Leitung L- zu erfassen und die erfassten Werte der Steuereinrichtung 5 bereitzustellen. Die Steuereinrichtung 5 weist einen analog/digital-Wandler 11 auf, um die von dem Spannungssensor und Stromsensor 9 erfassten Werte zu digitalisieren. Die digitalisierten Werte werden daraufhin in einem Speicher 12 gespeichert, um den Verlauf der Spannung und den Verlauf der Stromstärke in der spannungsführenden Leitung L- zu speichern. Eine Transformationseinrichtung 13 transformiert daraufhin die gespeicherten Verläufe von dem Zeitbereich in den Frequenzbereich. Dies geschieht insbesondere mittels einer Fast-Fourier-Transformation. Abschließend analysiert die Auswerteeinrichtung 14 die transformierten Verläufe im Frequenzbereich und identifiziert diejenigen Frequenzen, bei welchen die Impedanz der spannungsführenden Leitungen Iokale Minima aufweist. Die Auswerteeinrichtung 14 ist ferner dazu ausgebildet, das Abschaltsignal 6 auszugeben, wenn mindestens eine der identifizierten Frequenzen in mindestens einem vorgegebenen Frequenzbereich zur Erkennung eines Lebewesens LW liegt. Wird das Abschaltsignal 6 ausgegeben, trennt der Schütz SV die zwei spannungsführenden Leitung L+, L. von der Batterie B.

Der vorgegebene Frequenzbereich kann zwischen 0 Hz und 1 MHz Hz liegen. Soll als Lebewesen ein Mensch erkannt werden, kann der Frequenzbereich insbesondere zwischen 1 kHz Hz und 100Hz Hz liegen

Die Impedanz errechnet sich dabei aus dem Ohmeschen Gesetz nach der Formel Z=U/I.

In weiteren Ausführungsformen kann die Erfassungseinrichtung 4 einen Shunt-Widerstand oder einen kontaktlosen Stromsensor aufweisen.

Fig. 4 einen Schaltplan, der die elektrische Ersatzschaltung eines Menschen darstellt.

Die Ersatzschaltung für einen Menschen, welche in Fig. 4 dargestellt ist, ist durch die Norm IEC_60850, IEC_61010 vorgegeben.

Die Ersatzschaltung besteht aus einer Parallelschaltung eines Widerstands Rs mit einem Kondensator Cs und in Serie dazu einem Widerstand Rb, dem ein Widerstand R1 in Serie mit einem Kondensator C1 parallelgeschaltet sind.

Gemäß Norm IEC_60850, IEC_61010 hat der Widerstand Rs einen Widerstandswert von 1kOhm Ohm, der Kondensator Cs eine Kapazität von 0,22µF µF, der Widerstand Rb einen Widerstandswert von 500 Ohm, der Widerstand R1 einen Widerstandswert von 10k Ohm und der Kondensator C1 eine Kapazität von 0,022µF µF.

Anhand dieses Ersatzschaltbildes ist es möglich, die Frequenz zu berechnen, bei welcher die Ersatzschaltung eine minimale Impedanz aufweist. Diese Frequenz entspricht der Resonanzfrequenz des dargestellten Ersatzschaltbildes und damit auch der Resonanzfrequenz des menschlichen Körpers.

Fig. 5 zeigt ein Diagramm in welchem eine frequenzabhängigen Impedanz dargestellt ist.

In dem Prinzip-Diagramm in Fig. 5 ist auf der Ordinatenachse eine Impedanz Z aufgetragen. Auf der Abszissenachse des Diagramms ist die Frequenz aufgetragen. In dem Diagramm ist ferner eine Impedanzkurve aufgetragen, welche von 0Hz bis ca. 1 MHz bei einer hohen, durch parasitäre Effekte bestimmten Impedanz verläuft. Die Impedanz kurve weist für eine beispielhafte Auslegung ein erstes Minimum z.B. bei der Frequenz 1kHz von ca. 0,4Ohm und ein zweites deutlich weniger ausgeprägtes Minimum z.B. um 30kHz auf.

Die Frequenz, bei welcher sich das erste Minimum befindet, entspricht der Resonanzfrequenz des Schwingkreises aus Zwischenkreiskondensator C und den parasitären Widerständen zwischen der Batterie B und dem Zwischenkreiskondensator C.

Die Frequenz, bei der sich das zweite Minimum der Impedanzkurve befindet, entspricht der Resonanzfrequenz der unter Fig. 4 dargestellten Ersatzschaltung. Alleine das Vorhandensein des zweiten Minimums erlaubt es der Auswerteeinrichtung festzustellen, dass ein Lebewesen die zwei spannungsführenden Leitungen L+, L- berührt. Der Absolutwert der Impedanz bei dieser Frequenz ist nicht ausschlaggebend.

Obwohl die vorliegende Erfindung anhand bevorzugter Ausführungsbeispiele vorstehend beschrieben wurde, ist sie darauf nicht beschränkt, sondern auf vielfältige Art und Weise modifizierbar. Insbesondere lässt sich die Erfindung in mannigfaltiger Weise verändern oder modifizieren, ohne vom Kern der Erfindung, definiert durch die nachfolgenden Ansprüche, abzuweichen.

## Patentansprüche

1. Schutzvorrichtung (1) für ein IT-Netz mit einer ersten und einer zweiten spannungsführenden Leitung (L+, L-)
mit einem Signalgenerator (2), welcher dazu ausgebildet ist, ein erstes Signal (3) in die erste und/oder die zweite spannungsführende Leitung (L+, L-) einzuspeisen;
mit einer Erfassungseinrichtung (4), welche dazu ausgebildet ist, den Verlauf des eingespeisten ersten Signals (3) in mindestens einer der spannungsführenden Leitungen (L+, L-) zu erfassen;
mit einer Steuereinrichtung (5), welche dazu ausgebildet ist, den erfassten Verlauf zu analysieren und ein Abschaltsignal (6) auszugeben, wenn die Analyse des erfassten Verlaufs ein Berühren der ersten spannungsführenden Leitung (L+, L-) und der zweiten spannungsführenden Leitung (L-, L+) durch ein Lebewesen (LW) anzeigt,
**dadurch gekennzeichnet, dass**
die Steuereinrichtung (5) einen Speicher (12) aufweist, welcher dazu ausgebildet ist, eine Vielzahl von für den Verlauf des eingespeisten ersten Signals (3) in der mindestens einen spannungsführenden Leitung (L+, L-) kennzeichnenden digitalen Werten zu speichern;
die Steuereinrichtung (5) eine Transformationseinrichtung (13) aufweist, welche dazu ausgebildet ist, für den gespeicherten zeitlichen Verlauf des eingespeisten ersten Signals (3) eine Transformation in den Frequenzbereich, insbesondere eine Fast-Fourier-Transformation, durchzuführen und Daten auszugeben, welche den Verlauf des eingespeisten ersten Signals (3) im Frequenzbereich kennzeichnen; und
die Steuereinrichtung (5) eine Auswerteeinrichtung (14) aufweist, welche dazu ausgebildet ist, in den ausgegebenen Daten diejenigen Frequenzen zu identifizieren, bei welchen die Impedanz der spannungsführenden Leitungen Iokale Maxima oder Minima aufweist, und das Abschaltsignal (6) auszugeben, wenn mindestens eine der identifizierten Frequenzen in mindestens einem vorgegebenen Frequenzbereich zur Erkennung eines Lebewesens (LW) liegt.

2. Schutzvorrichtung nach Anspruch 1,
wobei der Signalgenerator (2) eine steuerbare Spannungsquelle und/oder eine steuerbare Stromquelle aufweist und das erste Signal (3) ein Spannungsimpuls oder ein Stromimpuls ist; oder
wobei der Signalgenerator (2) eine Spule (7) mit einem Schaltelement (8) aufweist, wobei das Schaltelement (8) dazu ausgebildet ist, die Spule (7) mit einer Spannungsquelle zu verbinden und die Spule (7) zum Erzeugen des ersten Signals (3) in Form eines Spannungsimpulses von der Spannungsquelle zu trennen.

3. Schutzvorrichtung nach einem der vorherigen Ansprüche 1 und 2,
wobei die Erfassungseinrichtung (4) einen Spannungssensor (9), welcher dazu ausgebildet ist, eine Spannung in der mindestens einen spannungsführenden Leitung (L+, L-) zu erfassen, und/oder einen Stromsensor, welcher dazu ausgebildet ist, eine Stromstärke in der mindestens einen spannungsführenden Leitung (L+, L-) zu erfassen, aufweist.

4. Schutzvorrichtung nach Anspruch 3
wobei die Steuereinrichtung (5) einen analog/digital-Wandler (11) aufweist, welcher dazu ausgebildet ist, die erfasste Spannung und/oder die erfasste Stromstärke in einen für die erfasste Spannung und/oder die erfasste Stromstärke kennzeichnenden digitalen Wert zu wandeln.

5. Verfahren zum Schutz von Lebewesen für ein IT-Netz mit einer ersten und einer zweiten spannungsführenden Leitung (L+, L-), mit den Schritten:
Einspeisen (S1) eines ersten Signals (3) in die erste und/oder die zweite spannungsführende Leitung (L+, L-);
Erfassen (S2) des Verlaufs des eingespeisten ersten Signals (3) in der mindestens einen spannungsführenden Leitung (L+, L-);
Analysieren (S3) des erfassten Verlaufs und Ausgeben eines Abschaltsignals (6), wenn die Analyse des erfassten Verlaufs ein Berühren der ersten spannungsführenden Leitung (L+, L-) und der zweiten spannungsführenden Leitung durch ein Lebewesen (LW) anzeigt,
wobei die erfasste Spannung und/oder die erfasste Stromstärke in einen für die erfasste Spannung und/oder die erfasste Stromstärke kennzeichnenden digitalen Wert gewandelt wird,
wobei eine Vielzahl von für den Verlauf des eingespeisten ersten Signals (3) in der mindestens einen spannungsführenden Leitung (L+, L-) kennzeichnenden digitalen Werten gespeichert werden;
wobei für den gespeicherten zeitlichen Verlauf des eingespeisten ersten Signals (3) eine Transformation in den Frequenzbereich, insbesondere eine Fast-Fourier-Transformation, durchgeführt wird und Daten ausgegeben werden, welche den Verlauf des eingespeisten ersten Signals (3) im Frequenzbereich kennzeichnen; und
wobei in den ausgegeben Daten diejenigen Frequenzen identifiziert werden, bei welchen die Impedanz der spannungsführenden Leitungen lokale Maxima oder Minima aufweist, und das Abschaltsignal (6) ausgegeben wird, wenn mindestens eine der identifizierten Frequenzen in mindestens einem vorgegebenen Frequenzbereich zur Erkennung eines Lebewesens (LW) liegt.

6. Verfahren nach Anspruch 5,
wobei ein Spannungsimpuls mit einer steuerbaren Spannungsquelle oder ein Stromimpuls mit einer steuerbaren Stromquelle erzeugt wird und als das erste Signal (3) in mindestens eine spannungsführende Leitung (L+, L-) eingespeist wird; oder
wobei ein Schaltelement (8) eine Spule (7) mit einer Spannungsquelle verbindet und die Spule (7) zum Erzeugen des ersten Signals (3) in Form eines Spannungsimpulses von der Spannungsquelle trennt.

7. Verfahren nach einem der vorherigen Ansprüche 5 und 6,
wobei eine Spannung in der mindestens einen spannungsführenden Leitung (L+, L-) erfasst wird, und/oder eine Stromstärke in der mindestens einen spannungsführenden Leitung (L+, L-) erfasst wird.

8. Energieversorgungsystem
mit mindestens einer Hochvoltbatterie (B),
mit einem Hochspannungszwischenkreis (ZK), welcher einen Zwischenkreiskondensator (C) aufweist;
mit mindestens zwei Hochspannungsleitungen (L+, L-), welche die Hochvoltbatterie (B) mit dem Zwischenkreiskondensator (C) verbinden;
mit mindestens einer steuerbaren Schaltvorrichtung (SV), welche dazu ausgebildet ist, die zwei Hochspannungsleitungen (L+, L-) elektrisch von der Hochvoltbatterie (B) zu trennen;
mit einer Schutzvorrichtung (1) nach einem der Ansprüche 1 - 5, welche zumindest mit einer der Hochspannungsleitungen (L+, L-) gekoppelt ist und welche dazu ausgebildet ist, die mindestens eine steuerbare Schaltvorrichtung (SV) mittels eines Abschaltsignals (6) derart anzusteuern, dass diese die zwei Hochspannungsleitungen (L+, L-) elektrisch von der Hochvoltbatterie (B) trennt, wenn ein Berühren der spannungsführenden Leitungen (L+, L-) durch ein Lebewesen (LW) erkannt wird.

## Claims

1. Protection apparatus (1) for an IT grid comprising a first and a second live line (L+, L-),
comprising a signal generator (2), which is designed to feed a first signal (3) into the first and/or the second live line (L+, L-);
comprising a detection device (4), which is designed to detect the characteristic of the fed-in first signal (3) in at least one live line (L+, L-) ; and
comprising a control device (5), which is designed to analyze the detected characteristic and to output a disconnection signal (6) when the analysis of the detected characteristic indicates that the first live line (L+, L-) and the second live line (L+, L-) are being touched by a living organism (LW),
**characterized in that** the control device (5) has a memory (12), which is designed to store a multiplicity of digital values which are characteristic of the characteristic of the fed-in first signal (3) in the at least one live line (L+, L-) ;
the control device (5) comprises a transformation device (13), which is designed to implement a transform into the frequency range, in particular a fast Fourier transform, for the stored characteristic over time of the fed-in first signal (3) and to output data which characterize the characteristic of the fed-in first signal (3) in the frequency range; and
the control device (5) comprises an evaluation device (14), which is designed to identify, in the output data, those frequencies at which the impedance of the live lines has local maxima or minima and to output the disconnection signal (6) when at least one of the identified frequencies is in at least one predetermined frequency range for identification of a living organism (LW).

2. Protection apparatus according to Claim 1,
wherein the signal generator (2) comprises a controllable voltage source and/or a controllable current source, and the first signal (3) is a voltage pulse or a current pulse; or
wherein the signal generator (2) comprises a coil (7) comprising a switching element (8), wherein the switching element (8) is designed to connect the coil (7) to a voltage source and to isolate the coil (7) from the voltage source in order to generate the first signal (3) in the form of a voltage pulse.

3. Protection apparatus according to either of the preceding Claims 1 and 2,
wherein the detection device (4) comprises a voltage sensor (9), which is designed to detect a voltage in the at least one live line (L+, L-), and/or a current sensor, which is designed to detect a current intensity in the at least one live line (L+, L-).

4. Protection apparatus according to Claim 3,
wherein the control device (5) comprises an analog-to-digital converter (11), which is designed to convert the detected voltage and/or the detected current intensity into a digital value which is characteristic of the detected voltage and/or the detected current intensity.

5. Method for protecting living organisms for an IT grid comprising a first and a second live line (L+, L-), said method comprising the following steps:
feeding (S1) a first signal (3) into the first and/or the second live line (L+, L-);
detecting (S2) the characteristic of the fed-in first signal (3) in the at least one live line (L+, L-);
analyzing (S3) the detected characteristic and outputting a disconnection signal (6) when the analysis of the detected characteristic indicates that the first live line (L+, L-) and the second live line are being touched by a living organism (LW),
wherein the detected voltage and/or the detected current intensity is converted into a digital value which is characteristic of the detected voltage and/or the detected current intensity,
wherein a multiplicity of digital values which are characteristic of the characteristic of the fed-in first signal (3) in the at least one live line (L+, L-) are stored;
wherein, for the stored characteristic over time of the fed-in first signal (3), a transform into the frequency range, in particular a fast Fourier transform, is implemented, and data which characterize the characteristic of the fed-in first signal (3) in the frequency range are output; and
wherein, in the output data, those frequencies at which the impedance of the live lines has local maxima or minima are identified, and the disconnection signal (6) is output when at least one of the identified frequencies is in at least one predetermined frequency range for identification of a living organism (LW).

6. Method according to Claim 5,
wherein a voltage pulse is generated by a controllable voltage source or a current pulse is generated by a controllable current source, and said voltage pulse or said current pulse is fed as the first signal (3) into at least one live line (L+, L-); or
wherein a switching element (8) connects a coil (7) to a voltage source and isolates the coil (7) from the voltage source in order to generate the first signal (3) in the form of a voltage pulse.

7. Method according to either of the preceding Claims 5 and 6,
wherein a voltage in the at least one live line (L+, L-) is detected and/or a current intensity in the at least one live line (L+, L-) is detected.

8. Power supply system
comprising at least one high-voltage battery (B),
comprising a high-voltage intermediate circuit (ZK), which comprises an intermediate circuit capacitor (C);
comprising at least two high-voltage lines (L+, L-), which connect the high-voltage battery (B) to the intermediate circuit capacitor (C);
comprising at least one controllable switching device (SV), which is designed to electrically isolate the two high-voltage lines (L+, L-) from the high-voltage battery (B);
comprising a protection apparatus (1) according to one of Claims 1 - 5, which protection apparatus is coupled at least to one of the high-voltage lines (L+, L-) and is designed to actuate the at least one controllable switching apparatus (SV) by means of a disconnection signal (6) in such a way that said controllable switching apparatus electrically isolates the two high-voltage lines (L+, L-) from the high-voltage battery (B) when it is identified that the live lines (L+, L-) are being touched by a living organism (LW).

## Revendications

1. Dispositif de protection (1) pour un réseau informatique comportant des première et deuxième lignes de tension électrique (L+, L-),
un générateur de signal (2) qui est conçu pour injecter un premier signal (3) dans la première et/ou la deuxième ligne de tension électrique (L+, L-) ;
un système de détection (4) qui est conçu pour détecter la courbe du premier signal (3) injecté dans au moins l'une des lignes de tension électrique (L+, L-) ;
un système de commande (5) qui est conçu pour analyser la courbe détectée et pour délivrer un signal de déconnexion (6) lorsque l'analyse de la courbe détectée indique un contact entre la première ligne de tension électrique (L+, L-) et la deuxième ligne de tension électrique (L-, L+) par l'intermédiaire d'un être vivant (LW),
**caractérisé en ce que** le système de commande (5) comporte une mémoire (12) conçue pour stocker une pluralité de valeurs numériques caractérisant la courbe du premier signal injecté (3) dans l'au moins une ligne de tension électrique (L+, L-) ;
le système de commande (5) comporte un système de transformation (13) conçu pour exécuter, pour la courbe temporelle stockée du premier signal injecté (3), une transformation dans le domaine fréquentiel, notamment une transformation de Fourier rapide, et pour délivrer des données qui caractérisent la courbe du premier signal injecté (3) dans le domaine fréquentiel ; et
le système de commande (5) comporte un système d'évaluation (14) conçu pour identifier dans les données délivrées les fréquences pour lesquelles l'impédance des lignes de tension électrique présente des maxima ou des minima locaux et pour délivrer le signal de déconnexion (6) lorsqu'au moins l'une des fréquences identifiée se situe dans au moins un domaine de fréquences prédéterminé pour détecter un être vivant (LW).

2. Dispositif de protection selon la revendication 1,
dans lequel le générateur de signal (2) comporte une source de tension pouvant être commandée et/ou une source de courant pouvant être commandée et le premier signal (3) est une impulsion de tension ou une impulsion de courant ; ou
dans lequel le générateur de signal (2) comporte une bobine (7) ayant un élément de commutation (8), dans lequel l'élément de commutation (8) est conçu pour relier la bobine (7) à une source de tension et pour séparer la bobine (7) de la source de tension afin de générer le premier signal (3) sous la forme d'une impulsion de tension.

3. Dispositif de protection selon l'une quelconque des revendications 1 et 2 précédentes,
dans lequel le système de détection (4) comporte un capteur de tension (9) conçu pour détecter une tension dans l'au moins une ligne de tension électrique (L+, L) et/ou un capteur de courant conçu pour détecter une intensité de courant dans l'au moins une ligne de tension électrique (L+, L-).

4. Dispositif de protection selon la revendication 3,
dans lequel le système de commande (5) comporte un convertisseur analogique/numérique (11) conçu pour convertir la tension détectée et/ou l'intensité dé courant détectée en une valeur numérique caractérisant la tension détectée et/ou l'intensité de courant détectée.

5. Procédé de protection d'êtres vivants pour un réseau informatique comportant des première et deuxième lignes de tension électrique (L+, L-) comprenant les étapes consistant à :
injecter (S1) un premier signal (3) dans la première et/ou la deuxième ligne de tension électrique (L+, L-) ;
détecter (S2) la courbe du premier signal (3) injecté dans au moins l'une des lignes de tension électrique (L+, L-) ;
analyser (S3) la courbe détectée et délivrer un signal de déconnexion (6) lorsque l'analyse de la courbe détectée indique un contact entre la première ligne de tension électrique (L+, L-) et la deuxième ligne de tension électrique par l'intermédiaire d'un être vivant (LW),
dans lequel la tension détectée et/ou l'intensité de courant détectée est convertie en une valeur numérique caractérisant la tension détectée et/ou l'intensité de courant détectée,
dans lequel une pluralité de valeurs numériques caractérisant la courbe du premier signal injecté (3) dans l'au moins une ligne de tension électrique (L+, L-) sont stockées ;
dans lequel, pour la courbe temporelle stockée du premier signal injecté (3), une transformation est exécutée dans le domaine fréquentiel, notamment une transformation de Fourier rapide, et des données sont délivrées, lesquelles données caractérisent la courbe du premier signal injecté (3) dans le domaine fréquentiel ; et
dans lequel les fréquences pour lesquelles l'impédance des lignes de tension électrique présente des maxima ou des minima locaux sont identifiées dans les données délivrées, et le signal de déconnexion (6) est délivré lorsqu'au moins l'une des fréquences identifiée se situe dans au moins un domaine de fréquence prédéterminé pour détecter un être vivant (LW).

6. Procédé selon la revendication 5,
dans lequel une impulsion de tension est générée au moyen d'une source de tension pouvant être commandée ou une impulsion de courant est générée au moyen d'une source de courant pouvant être commandée et est injectée en tant que premier signal (3) dans au moins une ligne de tension (L+, L-) ;
ou dans lequel un élément de commutation (8) relie une bobine (7) à une source de tension et sépare la bobine (7) de la source de tension afin de générer le premier signal (3) sous la forme d'une impulsion de tension.

7. Procédé selon l'une quelconque des revendications 5 et 6 précédentes,
dans lequel une tension est détectée dans l'au moins une ligne de tension électrique (L+, L-) et/ou une intensité de courant est détectée dans l'au moins une ligne de tension électrique (L+, L-).

8. Système d'alimentation en énergie,
comportant au moins une batterie à haute tension (B), un circuit intermédiaire à haute tension (ZK) qui comporte un condensateur de circuit intermédiaire (C) ; au moins deux lignes à haute tension (L+, L-) qui relient la batterie à haute tension (B) au condensateur de circuit intermédiaire (C) ;
au moins un dispositif de commutation pouvant être commandé (SV) conçu pour séparer électriquement les deux lignes à haute tension (L+, L-) de la batterie à haute tension (B) ;
un dispositif de protection (1) selon l'une quelconque des revendications 1-5, qui est couplé à au moins l'une des lignes à haute tension (L+, L-) et est conçu pour attaquer l'au moins un dispositif de commutation pouvant être commandé (SV) au moyen d'un signal de déconnexion (6) de manière à ce qu'il sépare électriquement les deux lignes à haute tension (L+, L-) de la batterie à haute tension (B) lorsqu'un contact entre les lignes de tension électrique (L+, L-) par l'intermédiaire d'un être vivant (LW) est détecté.
